# EUROPÄISCHE PATENTSCHRIFT

(11) **EP 1 533 876 B1**
(45) Veröffentlichungstag und Bekanntmachung des Hinweises auf die Patenterteilung: **17.07.2013**
(21) Anmeldenummer: 04026958.1
(22) Anmeldetag: 12.11.2004
(51) Int. Cl.: H01S 5/183

(54) **Polarisationskontrolle von Vertikaldiodenlasern durch ein monolithisch integriertes Oberflächengitter**
Polarisation control of vercial cavity diode lasers by a monolithically integrated surface grating
Contrôle de polarisation dans une diode laser verticale utilisant un réseau monolithiquement intégré

(30) Priorität: 18.11.2003 DE 10353951
(43) Veröffentlichungstag der Anmeldung: 25.05.2005
(73) Patentinhaber: U-L-M Photonics GmbH, 89081 Ulm (DE)
(72) Erfinder: Ostermann, Johannes Michael, 89075 Ulm (DE); Debernardi, Pierluigi, 10136 Torino (IT)
(74) Vertreter: Volmer, Georg

(56) Entgegenhaltungen:
- WO-A-03/088439
- US-A1- 2002 163 947
- US-A1- 2003 152 121
- COX J A ET AL: "GUIDED-MODE GRATING RESONANT FILTERS FOR VCSEL APPLICATIONS" PROCEEDINGS OF THE SPIE, SPIE, BELLINGHAM, VA, US, Bd. 3291, 28. Januar 1998 (1998-01-28), Seiten 70-76, XP009008494 ISSN: 0277-786X

## Beschreibung

Die Erfindung betrifft allgemein Vertikaldiodenlaser, und insbesondere Vertikaldiodenlaser, die zumindest eine strukturierte Schicht aufweisen, sowie deren Herstellung und Verwendung.

Diodenlaser nehmen bereits seit Mitte der 80er Jahre in der Lasertechnik eine überragende Stellung ein. Hohe Effizienz, Kompaktheit und einfachste Handhabung sind die wichtigsten Vorteile des Diodenlasers. Eingesetzt wurden sie bisher vor allem in der Kommunikations- und Informationstechnik, in Glasfasernetzen und CD-Playern bis hin zu Laserdruckern und professionellen Drucksystemen.

Als besonders vorteilhaft hat sich der Vertikaldiodenlaser (Vertical Cavity Surface Emitting Laser; VCSEL) erwiesen, der sich gegenüber den sogenannten Kantenemittern, die das Laserlicht parallel zum Substrat, also seitlich emittieren, vor allem durch einfachere Montage und Kühlung sowie bessere optische Eigenschaften des Laserlichtes auszeichnet. Weitere Vorteile sind ein geringerer Energieverbrauch und eine kompaktere elektrische Beschaltung, was insbesondere bei Großserienanwendungen Preisvorteile bietet, sowie die Einsatzmöglichkeit zum On-Wafer-Testing.

Anders als konventionelle Kantenemitter haben jedoch herkömmliche Vertikaldiodenlaser keine definierte Polarisationsrichtung. Während bei Kantenemittern die Lichtausbreitung parallel zum Quantenfilm erfolgt und sich damit die Übergangsmatrixelemente für die beiden Polarisationsrichtungen unterscheiden, steht der Ausbreitungswellenvektor bei VCSELn senkrecht auf den Quantenfilmen, wodurch der Gewinn für alle denkbaren Polarisationen gleich ist. Durch den zylinderförmigen Resonator herkömmlicher VCSEL wird ebenfalls keine Polarisation bevorzugt.

Der lineare elektrooptische Effekt verursacht bei VCSELn eine Deformation des Brechungsindexellipsoids entlang der-Kristallachsen [011] und [0-11] mit der Folge, dass die Polarisation der Grundmode einer Vertikallaserdiode meistens entlang einer dieser beiden Kristallachsen ausgerichtet ist. Die nächst höhere Mode ist im allgemeinen orthogonal zur Grundmode polarisiert. Durch eine Stromänderung oder eine zusätzliche äußere Verspannung kann es zu einem abrupten Wechsel der Polarisation einer Mode zwischen den beiden Kristallachsen kommen. Diese sogenannten Polarisationssprünge sind aufgrund des elektrooptischen Effekts mit einer Verschiebung der Emissionswellenlänge verbunden. Diese Polarisationssprünge limitieren generell den Einsatz von VCSELn in polarisationsabhängigen optischen Systemen. Beispielsweise sind die Polarisationssprünge nachteilig bei Drucksystemen, bei denen Medien bedruckt werden, die für verschiedene Polarisationen eine unterschiedliche Absorption aufweisen. Auch führen die Polarisationssprünge bei der optischen Datenübertragung zu einem erhöhten Rauschen. Außerdem können die Polarisationssprünge durch den Einfluß auf die Emissionswellenlänge den Einsatz in der Spektroskopie verhindern.

Aus US 5 995 531 ist beispielsweise bekannt, den oberen Spiegel eines VCSEL mit einem von der Kreisform abweichenden Querschnitt, zum Beispiel elliptisch, auszubilden, um so die Polarisation zu stabilisieren. Nachteilig hieran ist, dass bei einem von der Kreisform abweichenden Querschnitt des oberen Spiegels eines VCSEL das Einkoppeln in eine optische Faser, beispielsweise bei der optischen Datenübertragung, erschwert wird.

Zur Stabilisierung der Polarisation ist weiterhin bekannt, eine Vertikallaserdiode auf höher indizierten Substraten, beispielsweise auf einem [311]-Substrat, aufzubringen. Dies führt jedoch zu einer Verschlechterung der sonstigen Lasereigenschaften und erlaubt nur eine vorgegebene Polarisationsrichtung.

Neben vielen anderen, hier nicht beschriebenen, nicht zufriedenstellenden Ansätzen, ist früher bereits der Einsatz von Oberflächengittern zur Polarisationskontrolle versucht worden, jedoch hat auch dies bisher zu keinen zufriedenstellenden Ergebnissen geführt.
Aus der WO 03/088439A1 ist ein VCSEL mit einem "Guided Mode Grating Resonant Reflector Filter" (GMGRF) bekannt. Mit dem GMGRF soll die Wellenlänge des Lasers und/oder dessen Polarisation einstellbar sein. Das Gitter des GMGRF kann in den oberen Spiegel des VCSEL integriert sein.
Weiterhin ist aus der US 2002/0163947 A1 ein VCSEL bekannt, in welchem eine Strukturierung vorhanden ist, die eine photonische Bandlücke erzeugt. Diese Struktur verhindert den Durchtritt des Laserlichts. In der Strukturierung ist eine Apertur vorgesehen, durch welche das Laserlicht hindurchgelangt. Durch die photonische Bandlücke und die Apertur sollen unerwünschte Moden unterdrückt werden.

Der Erfindung liegt die Aufgabe zugrunde, einen Weg aufzuzeigen, wie die Polarisationsrichtung von ein- und mehrmodigen Vertikaldiodenlasern für alle Moden und alle Betriebsbedingungen beliebig relativ zur Kristallstruktur in eine bestimmte Richtung festgelegt werden kann.

Die Aufgabe wird in überraschend einfacher Weise durch den Gegenstand der unabhängigen Ansprüche gelöst. Vorteilhafte Ausführungsformen und Weiterbildungen sind in den Unteransprüchen definiert.

Dementsprechend umfasst ein erfindungsgemäßer Vertikaldiodenlaser zumindest ein Substrat, eine auf dem Substrat aufgebrachte erste Bragg-Reflektor-Schichtenfolge, eine auf der ersten Bragg-Reflektor-Schichtenfolge aufgebrachte aktive Schichtenfolge zur Erzeugung von Laserstrahlung, ein auf der aktiven Schichtenfolge aufgebrachte zweite Bragg-Reflektor-Schichtenfolge und Mittel zum Anlegen einer Spannung über die aktive Schichtenfolge, wobei zumindest die oberste Schicht der zweiten Bragg-Reflektor-Schichtenfolge periodisch strukturiert ist und wobei die Periode der Strukturierung und die Position der Strukturierung in Strahlrichtung des Lasers derart ausgewählt ist, dass die Polarisation des Lasers stabilisiert ist, die oberste Schicht der zweiten Bragg-Reflektor-Schichtenfolge eine Aussparung in Form eines Kreisringes mittig zur Lichtaustrittsfläche des Lasers aufweist, so dass die Grundmode des Lasers bevorzugt verstärkt wird und die Strukturierung auf einer kreisförmige Erhebung mittig zur Lichtaustrittsfläche des Lasers angeordnet ist. Die periodische Strukturierung wird als Gitter ausgebildet.

Die Bragg-Reflektor-Schichtenfolgen sind aufgebaut aus einer Vielzahl von Schichtpaaren, wobei jedes Paar jeweils eine hochbrechende und eine niedrigbrechende Schicht umfasst. Die Schichten haben eine Dicke, die der optischen Weglänge von 1/4 entspricht, mit 1 die Emissionswellenlänge des VCSEL. Beispielsweise können die Schichtpaare AlGaAs mit jeweils unterschiedlicher Konzentration von Aluminium aufweisen. Das Substrat könnte beispielsweise GaAs aufweisen. Es können aber auch beliebige andere geeignete Materialien verwendet werden. Die aktive Schichtenfolge weist zumindest einen, in der Regel mehrere Quantentöpfe auf (Multiple Quantum Wells; MQW).

Die Bragg-Reflektor-Schichtenfolgen können zu den beschriebenen 1/4-Schichten noch eine oder mehrere weitere Schichten aufweisen, die bevorzugt als oberste Schicht bzw. Schichten ausgebildet sein können. Auch eine dieser weiteren Schichten kann die periodische Strukturierung aufweisen.

Die Erfinder haben festgestellt, dass mittels einer periodischen Strukturierung, mittels eines Gitters, die Polarisation eines VCSEL stabilisiert und darüber hinaus auch definiert ausgerichtet werden kann. Dies gilt auch für mehrmodige VCSEL. Es konnte von den Erfindern beispielsweise experimentell gezeigt werden, dass auch bei stark mehrmodigen Vertikaldiodenlasern mit bis zu 14 Moden durch ein Oberflächengitter gemäß der Erfindung eine Unterdrückung der orthogonalen Polarisation von 15 dB über die gesamte Kennlinie bei einer Ausgangsleistung von bis zu 8 mW erreicht werden kann. Polarisationssprünge bei einer Änderung der Stromstärke oder der Temperatur oder bei Hinzufügen einer äußeren Vorspannung wurden über die gesamte Kennlinie nicht beobachtet.

Die Erfinder haben überraschend festgestellt, dass es für die Polarisationskontrolle eines VCSEL zwingend erforderlich ist, Position, Tiefe und Periode der periodischen Strukturierung sehr genau auszuwählen. Periode und Tiefe sind dabei stark von der Schichtstruktur abhängig.

Besonders vorteilhaft weist die periodische Strukturierung eine Periode zwischen 0,3 und 1,5 mm, insbesondere zwischen 0,6 und 1,0 mm, auf. Bei einer Emissionswellenlänge des Vertikaldiodenlasers von 1 weist die periodische Strukturierung bevorzugt einen Wert zwischen 0,5 1 und 1,5 1, insbesondere zwischen 0,7 1 und 1,3 1, auf.

Die periodische Strukturierung ist außerdem bevorzugt als Oberflächenstruktur der obersten Schicht der zweiten Bragg-Reflektor-Schichtenfolge, ausgebildet. Vorteilhaft kann die Strukturierung durch Aussparungen in dieser Schicht gebildet sein. Die Position der Aussparungen ist neben der Periode und der Tiefe der Strukturierung der Parameter, der die Polarisationseigenschaften des VCSEL erfindungsgemäß maßgeblich beeinflusst. Besonders vorteilhaft weisen die Aussparungen eine Tiefe zwischen 10 und 150 nm, insbesondere zwischen 40 und 90 nm, auf.

Für einen VCSEL mit einer Emissionswellenlänge von im wesentlichen 850 nm weist die Tiefe der Aussparungen bei einer Periode der Strukturierung von 0,7 mm bevorzugt Werte zwischen 40 - 70 nm auf.

Die periodische Strukturierung kann alternativ auch auf der obersten Schicht der zweiten Bragg-Reflektor- Schichtenfolge durch Aufbringen einer Struktur erfolgen, die zumindest ein Metall oder ein dielektrisches Material aufweist.

Es kann auch zumindest eine weitere Schichtaufgebracht und diese strukturiert werden. Auch liegt das Aufbringen weitere Schichten ober- und unterhalb der strukturierten Schicht mit unterschiedlichen Dicken im Rahmen der Erfindung.

Wie erwähnt kann die periodische Strukturierung auch durch auf die oberste Schicht der zweiten Bragg-Reflektor-Schichtenfolge aufgebrachte Erhebungen gebildet werden. Hierzu kann die oberste 1/4-Schicht der zweiten Bragg-Reflektor-Schichtenfolge zunächst ausgedünnt werden. Dies kann durch Aufbringen der obersten Schicht mit einer geringeren Dicke als 1/4 oder durch nachträgliches ganzflächiges Ätzen dieser Schicht erfolgen.

Es liegt auch im Rahmen der Erfindung, die beschriebene periodische Strukturierung mit einem Oberflächen- Relief (Surface Relief) zu kombinieren, um die Leistung ausgewählter Lasermoden zu erhöhen.

Das Oberflächen-Relief kann prinzipiell auf zwei Arten ausgebildet sein. Die oberste Schicht der zweiten Bragg-Reflektor-Schichtenfolge kann eine Aussparung aufweisen oder es kann auf die oberste Schicht der zweiten Bragg-Reflektor-Schichtenfolge eine weitere Schicht mit einer geeigneten Strukturierung aufgebracht sein.

Zur Erhöhung der Leistung der Grundmode weist die oberste Schicht der zweiten Bragg-Reflektor-Schichtenfolge eine Aussparung in Form eines Kreisringes unterschiedlicher Dicke mittig zur Lichtaustrittsfläche des Lasers aufweisen, wodurch nur eine Fläche in der Mitte der Lichtaustrittsfläche mit einer Dicke von im wesentlichen 1/4 verbleibt.

Ein erfindungsgemäßes Verfahren zur Herstellung eines polarisationsstabilen VCSEL umfasst das Bereitstellen eines Substrats, das Aufbringen einer ersten Bragg-Reflektor-Schichtenfolge auf das Substrat, das Aufbringen einer aktiven Schichtenfolge auf die erste Bragg-Reflektor-Schichtenfolge zur Erzeugung von Laserstrahlung, das Aufbringen einer zweiten Bragg-Reflektor-Schichtenfolge auf die aktive Schichtenfolge, sowie das Vorsehen eines Mittels zum Anlegen einer Spannung über die aktive Schichtenfolge, wobei zumindest die oberste Schicht der zweiten Bragg-Reflektor-Schichtenfolge periodisch strukturiert aufgebracht wird und wobei die Periode, die Tiefe und die Position der Strukturierung in Strahlrichtung des Lasers derart ausgewählt wird, dass die Polarisation des Lasers stabilisiert ist gekennzeichnet durch den Schritt des Ätzens einer Aussparung mit einem Querschnitt in Form eines Kreisringes in die oberste Schicht der zweiten Bragg-Reflektor-Schichtenfolge, so dass eine kreisförmige Erhebung mittig zur Lichtaustrittsfläche des Lasers gebildet wird, so dass die Leistung der Grundmode des Lasers bevorzugt verstärkt wird und die Strukturierung auf der kreisförmige Erhebung mittig zur Lichtaustrittsfläche des Lasers angeordnet ist.

Das Aufbringen der zumindest einen Schicht mit einer periodischen Strukturierung umfasst das Aufbringen einer Schicht, die eine Gitterstruktur aufweist.

Die bei dem erfindungsgemäßen Verfahren zum Herstellen eines polarisationsstabilen VCSEL bevorzugt einzuhaltende Periode , Tiefe und Position der Strukturierung in Strahlrichtung entspricht den oben für den VCSEL beschriebenen.

Besonders bevorzugt wird die oberste Schicht der zweiten Bragg-Reflektor-Schichtenfolge periodisch strukturiert aufgebracht, wobei insbesondere die Oberfläche der Schicht strukturiert wird.

Vorteilhaft kann die Strukturierung mittels üblicher photolithographischer Methoden erfolgen, wobei Gräben in die Oberfläche der Schicht mit trockenchemischen und/oder nasschemischen und/oder physikalischen Ätzverfahren geätzt werden. Die Ätztiefe beträgt dabei bevorzugt zwischen 10 und 150 nm, insbesondere zwischen 40 und 90 nm.

Eine alternative Variante des Aufbringens der zumindest einen Schicht mit einer periodischen Strukturierung sieht vor, die oberste Schicht der zweiten Bragg-Reflektor-Schichtenfolge zunächst gegenüber der Dicke von üblicherweise 1/4 auszudünnen. Dies kann dadurch erfolgen, dass bereits das Aufbringen der Schicht mit einer geringeren Dicke erfolgt oder durch nachträgliches Ätzen. Bevorzugt liegt die Schichtdicke, um die die oberste Schicht der zweiten Bragg-Reflektor-Schichtenfolge ausgedünnt wird, zwischen 10 und 150 nm, insbesondere zwischen 40 und 90 nm.

Auf die ausgedünnte Schicht wird in dieser Variante weiteres Material strukturiert abgeschieden, wobei hierfür beispielsweise ein dielektrisches Material oder ein Metall verwendet werden kann. Vorteilhaft können auch mehrere Materialien nacheinander abgeschieden werden, beispielsweise die Metalle Titan und Gold.

Für das bereits oben beschriebene Oberflächen-Relief zur Erhöhung der Leistung ausgewählter Lasermoden sieht das erfindungsgemäße Verfahren vor, zumindest eine Schicht von den Schichtenfolgen mit einer weiteren Strukturierung derart aufzubringen, dass die Leistung zumindest einer Lasermode bevorzugt verstärkt wird.

Zur Erhöhung der Leistung der Grundmode sieht das Verfahren vor, eine Aussparung mit einem Querschnitt in Form eines Kreisringes in die oberste Schicht der zweiten Bragg-Reflektor-Schichtenfolge zu ätzen, so dass eine Erhebung mittig zur Lichtaustrittsfläche des Lasers gebildet wird.

Es liegt weiterhin im Rahmen der Erfindung, ein System zur optischen Datenübertragung anzugeben, das einen erfindungsgemäßen Vertikaldiodenlaser umfasst.

Weiterhin umfasst die Erfindung ein spektroskopisches System, insbesondere zum Ausmessen von Absorptionslinien, das einen erfindungsgemäßen Vertikaldiodenlaser aufweist.

Die Erfindung wird nachfolgend beispielhaft anhand bevorzugter Ausführungsformen und unter Bezugnahme auf die beigefügten Zeichnungen genauer beschrieben. Dabei bezeichnen gleiche Bezugszeichen in den Zeichnungen gleiche oder ähnliche Teile.

Es zeigen:
Fig. 1: schematisch den Aufbau eines VCSEL,
Fig. 2A: eine schematische Aufsicht auf eine Ausführungsform eines erfindungsgemäßen VCSEL mit einem Oberflächengitter mit einer Periode von 0,7 mm,
Fig. 2B: eine schematische Aufsicht auf eine Ausführungsform eines erfindungsgemäßen VCSEL mit einem Oberflächengitter mit einer Periode von 0,9 mm.
Fig. 3: eine schematische Querschnittsansicht einer periodischen Strukturierung eines erfindungsgemäßen VCSEL
Fig. 4: eine schematische Querschnittsansicht und Aufsicht einer Ausführungsform eines erfindungsgemäßen VCSEL mit Oberflächen-Relief,

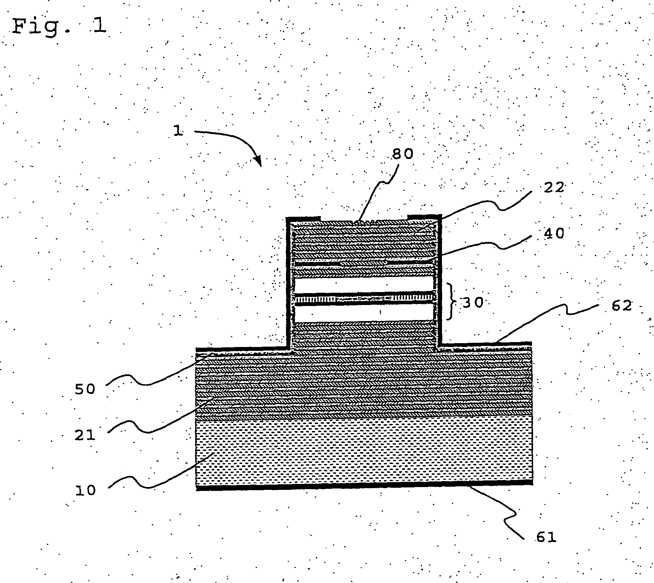

Fig. 1 zeigt schematisch den Aufbau eines VCSEL 1. Auf einem Substrat 10, beispielsweise ein GaAs-Substrat, ist eine erste Bragg- Reflektor-Schichtenfolge 21 aufgebracht. Zwischen dieser ersten Bragg-Reflektor-Schichtenfolge 21 und einer zweiten Bragg-Reflektor-Schichtenfolge 22 ist eine aktive Schichtenfolge 30 angeordnet, die mehrere Quantentöpfe aufweist und der Erzeugung der Laserstrahlung dient. Innerhalb der zweiten Bragg-Reflektor-Schichtenfolge 22 ist eine Oxid-Apertur 40 vorgesehen. Der VCSEL weist weiterhin metallische Kontaktflächen 61 und 62, sowie eine Isolation 50 auf. Alternativ könnte der VCSEL beispielsweise auch einen Intra-Cavity-Kontakt aufweisen. Die oberste Schicht der zweiten Bragg-Reflektor-Schichtenfolge 22 weist ein Oberflächengitter 80 mit in die Schicht geätzten, zueinander parallelen, Gräben auf.

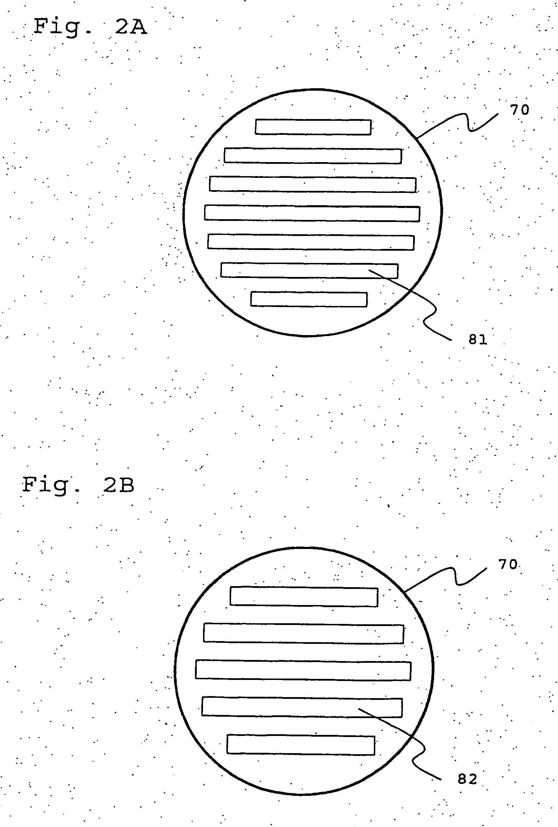

Verschiedene für VCSEL mit einer Emissionswellenlänge von 850 nm und 960 nm untersuchte Gitterstrukturen sind in den Fig. 2A und 2B in Aufsicht dargestellt. Gezeigt sind jeweils die Begrenzung des Kontaktrings 70, sowie in die oberste Schicht der zweiten Bragg-Reflektor-Schichtenfolge geätzte Gittergräben 81 und 82.

Die in den Fig. 2A und 2B dargestellten periodischen Strukturierungen weisen mittig einen Gittergraben auf. Die Strukturierung könnte hierzu auch in der Schichtebene verschoben sein. So könnte die periodische Strukturierung beispielsweise auch eine mittige Erhebung aufweisen.

In Fig. 2A beträgt die Gitterperiode 0,7 µm. Bei dieser Gitterperiode konnte für Ätztiefen von 50 nm der Gittergräben ein starker Einfluss auf die Polarisationseigenschaften des VCSEL festgestellt werden.

Fig. 2B zeigt ein Oberflächengitter mit einer Gitterperiode von 0,9 µm. Bei dieser Gitterperiode wurde nur ein geringer Einfluss auf die Polarisationseigenschaften des VCSEL festgestellt.

Hieraus wird ersichtlich, dass Periode, Ätztiefe und Position sehr genau ausgewählt werden müssen, um einen optimalen Effekt auf die Polarisationseigenschaften des VCSEL zu erzielen. Dies ist sicherlich ein Grund, weshalb aus dem Stand der Technik bekannte Gitterstrukturen bisher zu keinem zufriedenstellenden Ergebnis geführt haben.

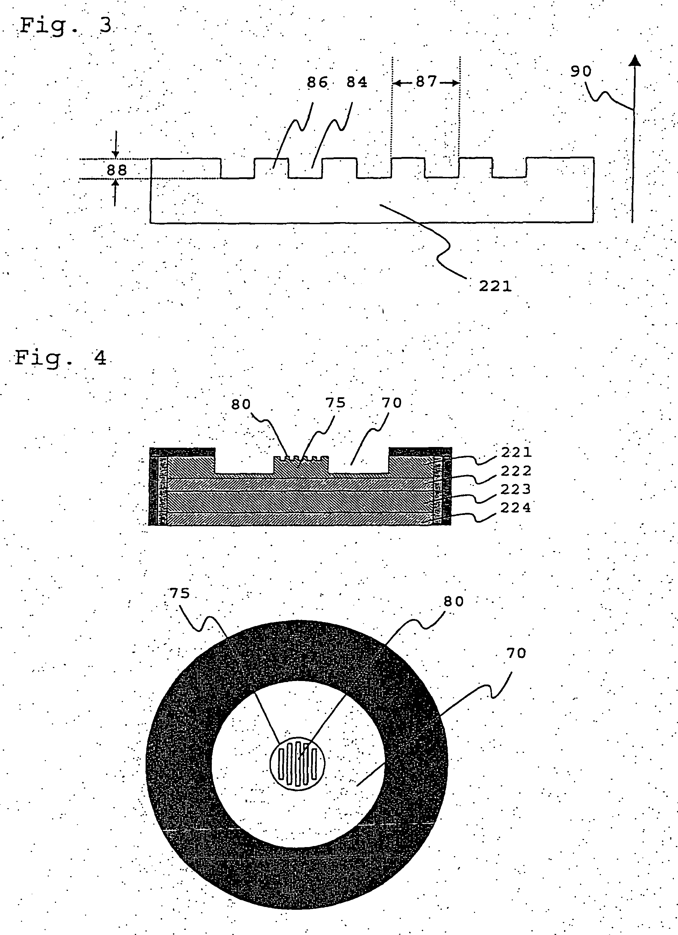

Fig. 3 zeigt eine schematische Querschnittsansicht einer periodischen Strukturierung eines erfindungsgemäßen VCSEL, die durch Ätzen von Gittergräben 84 in die oberste Schicht 221 der zweiten Bragg-Reflektor-Schichtenfolge 22 hergestellt ist. Die Strukturierung weist eine Periodizität in einer Richtung parallel zur Schichtebene auf, gebildet durch abwechselnde Aussparungen 84 und Erhebungen 86. Die Aussparungen 84 und Erhebungen 86 weisen in diesem Ausführungsbeispiel einen im wesentlichen rechteckigen Querschnitt mit steilen Kanten auf. Die Kanten können jedoch auch abgeflacht sein, insbesondere bei Einsatz üblicher nasschemischer Ätzverfahren. Auch andere Formen, wie beispielsweise eine Sägezahn- oder Wellen-Form, liegen im Rahmen der Erfindung.

Die Aussparungen 84 und Erhebungen 86 weisen in diesem Ausführungsbeispiel eine im wesentlichen identische Breite auf. Eine unterschiedliche Breite der Aussparungen 84 und Erhebungen 86 liegt aber ebenso im Rahmen der Erfindung.

Bei einer hinreichenden Position der Strukturierung ist neben neben der Ätztiefe 88 die Periode 87 der Strukturierung maßgeblich für die Polarisationseigenschaften des VCSEL.

Die in Fig. 4 dargestellte Ausführungsform eines erfindungsgemäßen VCSEL umfasst eine weitere Strukturierung der obersten Schicht der zweiten Bragg-Reflektor-Schichtenfolge, durch die ein Oberflächen-Relief 75 zur Unterdrückung von Lasermoden höherer Ordnung gebildet wird. Dargestellt sind die obersten vier Schichten 221 bis 224 der zweiten Bragg-Reflektor-Schichtenfolge. In die oberste Schicht 221 ist eine Aussparung mit einem Querschnitt in Form eines Kreisringes geätzt, so dass ein kreisförmiges Oberflächen-Relief 75 verbleibt. Die periodische Strukturierung 80 zur Kontrolle der Polarisation des VCSEL ist in diesem Ausführungsbeispiel auf dem Oberflächen-Relief 75 angeordnet.

## Patentansprüche

1. Vertikaldiodenlaser (1), zumindest umfassend
ein Substrat (10),
ein auf dem Substrat aufgebrachte erste Bragg-Reflektor-Schichtenfolge (21),
eine auf der ersten Bragg-Reflektor-Schichtenfolge (21) aufgebrachte aktive Schichtenfolge (30) zur Erzeugung von Laserstrahlung,
ein auf der aktiven Schichtenfolge (30) aufgebrachte zweite Bragg-Reflektor-Schichtenfolge (22) und
Mittel zum Anlegen einer Spannung über die aktive Schichtenfolge (30), wobei zumindest die oberste Schicht (221) der zweiten Bragg-Reflektor-Schichtenfolge (22) periodisch strukturiert ist und wobei die Periode (87) der Strukturierung (80) und die Position der Strukturierung in Strahlrichtung des Lasers (1) derart ausgewählt ist, dass die Polarisation des Lasers (1) stabilisiert ist,
**dadurch gekennzeichnet, dass**
die oberste Schicht (221) der zweiten Bragg-Reflektor-Schichtenfolge (22) eine Aussparung (70) in Form eines Kreisringes mittig zur Lichtaustrittsfläche des Lasers (1) aufweist, so dass die Grundmode des Lasers bevorzugt verstärkt wird und die Strukturierung (80) eine Gitterstruktur ist, die auf einer kreisförmige Erhebung (75) mittig zur Lichtaustrittsfläche des Lasers (1) angeordnet ist.

2. Vertikaldiodenlaser nach Anspruch 1, wobei die erste und zweite Bragg-Reflektor-Schichtenfolge eine Vielzahl von Schichtpaaren aufweisen, wobei jeweils eine Schicht eines Schichtpaares ein hochbrechendes Material aufweist und eine Schicht ein niedrigbrechendes Material aufweist und sich hochbrechende und niedrigbrechende Schichten in der Schichtenfolge abwechseln.

3. Vertikaldiodenlaser (1) nach Anspruch 2, wobei zumindest die zweite Bragg-Reflektor-Schichtenfoige (22) zumindest eine weitere Schicht aufweist.

4. Vertikaldiodenlaser (1) nach Anspruch 3, wobei die zumindest eine weitere Schicht die oberste Schicht der zweiten Bragg-Reflektor-Schichtenfolge bildet.

5. Vertikaldiodenlaser (1) nach einem der vorstehenden Ansprüche, wobei die periodische Strukturierung (80) eine Periode (87) zwischen 0,3 und 1,5 µm, insbesondere zwischen 0,6 und 1,0 µm, aufweist.

6. Vertikaldiodenlaser (1) nach einem der vorstehenden Ansprüche, wobei der Vertikaldiodenlaser eine Emissionswellenlänge von λ aufweist und die periodische Strukturierung (80) eine Periode (87) zwischen 0,5 λ und 1,5 λ, insbesondere zwischen 0,7 λ, und 1,3 λ, aufweist.

7. Vertikaldiodenlaser (1) nach einem der vorstehenden Ansprüche, wobei die periodische Strukturierung (80) durch Aussparungen (81, 82, 83, 84) in der obersten Schicht (221) der zweiten Bragg-Reflektor-Schichtenfolge (22) gebildet ist.

8. Vertikaldiodenlaser (1) nach Anspruch 7, wobei die Aussparungen (84) eine Tiefe (88) zwischen 10 und 150 nm, insbesondere zwischen 40 und 90 nm, aufweisen.

9. Vertikaldiodenlaser (1) nach einem der vorstehenden Ansprüche, wobei die periodische Strukturierung (80) durch auf die oberste Schicht (221) der zweiten Bragg-Reflektor-Schichtenfolge (22) aufgebrachte Erhebungen gebildet wird, wobei die oberste Schicht (221) der zweiten Bragg-Reflektor-Schichtenfolge (22) ausgedünnt ist.

10. Vertikaldiodenlaser (1) nach Anspruch 9, wobei die oberste Schicht (221) der zweiten Bragg-Reflektor-Schichtenfolge (22) zwischen 10 und 150 nm, insbesondere zwischen 40 und 90 nm, ausgedünnt ist.

11. Vertikaldiodenlaser (1) nach einem der vorstehenden Ansprüche, wobei der Vertikaldiodenlaser (1) eine Emissionswellenlänge von im wesentlichen 850 nm aufweist, die periodische Strukturierung (80) eine Periode (87) von im wesentlichen 0,7 µm aufweist und die Dicke (88) der periodischen Strukturierung (80) zwischen 40 und 70 nm liegt.

12. Verfahren zum Herstellen eines polarisationsstabilen Vertikaldiodenlasers, umfassend die Schritte
Bereitstellen eines Substrats (10),
Aufbringen einer ersten Bragg-Reflektor-Schichtenfolge (21) auf das Substrat (10),
Aufbringen einer aktiven Schichtenfolge (30) auf die erste Bragg-Reflektor-Schichtenfolge (21) zur Erzeugung von Laserstrahlung,
Aufbringen einer zweiten Bragg-Reflektor-Schichtenfolge (22) auf die aktive Schichtenfolge (30),
Vorsehen eines Mittels zum Anlegen einer Spannung über die aktive Schichtenfolge (30), wobei
zumindest die oberste Schicht (221) der zweiten Bragg-Reflektor-Schichtenfolge (22) mit einer periodischen Strukturierung (80) aufgebracht wird und wobei die Periode (87) der Strukturierung und die Position der Strukturierung in Strahlrichtung des Lasers (1) derart ausgewählt wird, dass die Polarisation des Lasers (1) stabilisiert ist,
**gekennzeichnet durch** den Schritt des Ätzens einer Aussparung (70) mit einem Querschnitt in Form eines Kreisringes in die oberste Schicht (221) der zweiten Bragg-Reflektor-Schichtenfolge (22), so dass eine kreisförmige Erhebung (75) mittig zur Lichtaustrittsfläche des Lasers (1) gebildet wird, so dass die Leistung der Grundmode des Lasers bevorzugt verstärkt wird und die Strukturierung (80) eine Gitterstruktur ist, die auf der kreisförmige Erhebung (75) mittig zur Lichtaustrittsfläche des Lasers (1) angeordnet ist.

13. Verfahren nach Anspruch 12, wobei die erste und zweite Bragg-Reflektor-Schichtenfolge als eine Vielzahl von Schichtpaaren aufgebracht wird, wobei jeweils eine Schicht eines Schichtpaares ein hochbrechendes Material aufweist und eine Schicht ein niedrigbrechendes Material aufweist und hochbrechende und niedrigbrechende Schichten abwechselnd aufgebracht.

14. Verfahren nach Anspruch 13, wobei zur Bildung der zweiten Bragg-Reflektor-Schichtenfolge (22) zumindest eine weitere Schicht aufgebracht wird.

15. Verfahren nach Anspruch 14, wobei die zumindest eine weitere Schicht als oberste Schicht der zweiten Bragg-Reflektor-Schichtenfolge aufgebracht wird.

16. Verfahren nach einem der vorstehenden Ansprüche, wobei die periodische Strukturierung (80) eine Periode (87) zwischen 0,3 und 1,5 µm, insbesondere zwischen 0,6 und 1,0 µm, aufweist.

17. Verfahren nach einem der vorstehenden Ansprüche, wobei der Vertikaldiodenlaser (1) eine Emissionswellenlänge von λ aufweist und die periodische Strukturierung (80) eine Periode (87) zwischen 0,5 λ und 1,5 λ, insbesondere zwischen 0,7 λ und 1,3 λ, aufweist.

18. Verfahren nach einem der vorstehenden Ansprüche, wobei das Aufbringen der zumindest einen Schicht (221) mit einer periodischen Strukturierung (80) den Schritt des Ätzens mittels üblicher trockenchemischer und/oder nasschemischer und/oder physikalischer Ätzverfahren umfasst.

19. Verfahren nach Anspruch 18, wobei der Schritt des Ätzens den Schritt des Ätzens von Gräben (81, 82, 83, 84) in die oberste Schicht der zweiten Bragg-Reflektor-Schichtenfolge (22) umfasst.

20. Verfahren nach Anspruch 19, wobei das Ätzen von Gräben (81, 82, 83, 84) in die oberste Schicht (221) der zweiten Bragg-Reflektor-Schichtenfolge (22) mit einer Ätztiefe (88) zwischen 10 und 150 nm, insbesondere zwischen 40 und 90 nm, erfolgt.

21. Verfahren nach einem der vorstehenden Ansprüche, wobei das Aufbringen der zumindest einen Schicht mit einer periodischen Strukturierung den Schritt des Abscheidens eines dielektrischen Materials und/oder zumindest eines Metalls umfasst.

22. Verfahren nach Anspruch 21, wobei das dielektrische Material und/oder das zumindest eine Metall auf der obersten Schicht der zweiten Bragg-Reflektor-Schichtenfolge (22) abgeschieden wird.

23. Verfahren nach Anspruch 22, wobei die oberste Schicht der zweiten Bragg-Reflektor-Schichtenfolge (22) ausgedünnt wird, insbesondere um eine Schichthöhe von zwischen 10 und 150 nm, insbesondere zwischen 40 und 90 nm.

24. Verfahren nach einem der vorstehenden Ansprüche, wobei die periodische Strukturierung (80) eine Periode (87) von im wesentlichen 0,7 µm aufweist und die Dicke (88) der periodischen Strukturierung (80) zwischen 40 und 70 nm liegt.

25. Verfahren nach einem der vorstehenden Ansprüche, wobei zumindest eine Schicht von den Schichtenfolgen mit einer weiteren Strukturierung aufgebracht wird derart, dass die Leistung zumindest einer Lasermode bevorzugt verstärkt wird.

26. System zur optischen Datenübertragung, das einen Vertikaldiodenlaser (1) nach einem der Ansprüche 1 bis 11 aufweist.

27. Spektroskopisches System, insbesondere zum Ausmessen von Absorptionslinien, das einen Vertikaldiodenlaser (1) nach einem der Ansprüche 1 bis 11 aufweist.

## Claims

1. Vertical cavity diode laser (1), at least comprising
a substrate (10),
a first Bragg reflector layer sequence (21) placed on the substrate,
a layer sequence of active layers (30) for generating laser radiation placed on the first Bragg reflector layer sequence (21),
a second Bragg reflector layer sequence (22) placed on the active layer sequence (30),
and means for applying a voltage across the active layer sequence (30), wherein at least the uppermost layer (221) of the second Bragg reflector layer sequence (22) is periodically patterned and the period (87) of the structure (80) and the position of the structure in the beam direction of the laser (1) is selected such that polarization of the laser (1) is stabilized,
**characterized in that**
the top layer (221) of the second Bragg reflector layer sequence (22) has a recess (70) in the form of a circular ring centred with respect to the light-emitting surface of the laser (1), such that the fundamental mode of the laser is preferably reinforced, and the structure (80) is a grating structure which is arranged on a circular elevation (75) centrally to the light-emitting surface of the laser (1).

2. The vertical cavity diode laser of claim 1, wherein said first and second Bragg reflector layer sequences comprise a plurality of layer pairs, wherein one layer of each layer pair has a high refractive index material and one layer has a low refractive index material, and the high refractive index and low refractive index layers alternate in the layer sequence.

3. The vertical cavity diode laser (1) according to claim 2, wherein at least the second Bragg reflector layer sequence (22) comprises at least one further layer.

4. The vertical cavity diode laser 1 according to claim 3, wherein at least one further layer comprises the second Bragg reflector layer sequence (22).

5. The vertical cavity diode laser according to any preceding claim, wherein the periodic structure (80) has a period 87 between 0.3 and 1.5 microns, in particular, between 0.6 and 1.0 micron.

6. The vertical cavity diode laser (1) according to any preceding claim, wherein the vertical cavity diode laser has an emission wavelength λ and the periodic structure (80) has a period (87) between 0.5 λ and 1.5 λ, in particular, between 0.7 λ and 1.3 λ.

7. The vertical cavity diode laser (1) according to any preceding claim, wherein the periodic structure (80) is formed by recesses (81, 82, 83, 84) in the top layer (221) of the second Bragg reflector layer sequence (22).

8. The vertical cavity diode laser (1) according to claim 7, wherein the recesses (84) have a depth (88) between 10 and 150 nm, in particular, between 40 and 90 nm.

9. The vertical cavity diode laser (1) according to any of the preceding claims, wherein the periodic structure (80) is formed by the elevations placed on the top layer (221) of the second Bragg reflector layer sequence (22), wherein the top layer (221) of the second Bragg reflector layer sequence (22) is thinned.

10. The vertical cavity diode laser (1) according to claim 9, wherein the top layer (221) of the second Bragg reflector layer sequence (22) is thinned to between 10 and 150 nm, in particular, between 40 and 90 nm.

11. The vertical cavity diode laser according to any of the preceding claims, wherein the vertical cavity diode laser (1) has an emission wavelength of substantially 850 nm, the periodic structure (80) has a period (87) of substantially 0.7 micron and the thickness (88) of the periodic structure (80) is between 40 and 70 nm.

12. A process for the manufacture of a polarization-stable vertical cavity diode laser, comprising the steps of
providing a substrate (10),
depositing a first Bragg reflector layer sequence (21) onto the substrate (10),
depositing an active layer sequence (30) on the first Bragg reflector layer sequence (21) for the generation of laser radiation,
applying a second Bragg reflector layer sequence (22) on the active layer sequence (30),
providing a means for applying a voltage across the active layer sequence (30), wherein
at least the top layer (221) of the second Bragg reflector layer sequence (22) is provided with a periodic structure (80), and wherein the period (87) of the structure and the position of the structure in the beam direction of the laser (1) are selected such that polarization of the laser (1) is stabilized,
**characterized by** the step of etching a recess (70) with a cross section in the shape of a circular ring in the top layer (221) of the second Bragg reflector layer sequence (22), so that a circular elevation (75) is formed centrally on the light-emitting surface of the laser (1), so that the power of the fundamental mode of the laser is preferably reinforced, and the structure (80) is a grating structure, which is formed on the centre of the circular elevation (75) centrally to the light-emitting surface of the laser (1).

13. The process according to claim 12, wherein said first and second Bragg reflector layer sequences are arranged as a plurality of layer pairs, wherein one layer of each layer pair has a high refractive index material and one layer has a low refractive index material, whereby the high refraction index and low refraction index layers alternate.

14. The process according to claim 13, wherein at least one further layer is placed in forming the second Bragg reflector layer sequence (22).

15. The process according to claim 14, wherein at least one further layer is placed as top layer of the second Bragg reflector layer sequence.

16. The process according to any of the preceding claims, wherein the periodic structure (80) has a period (87) between 0.3 and 1.5 microns, in particular, between 0.6 and 1.0 micron.

17. The process according to any of the preceding claims, wherein the vertical cavity diode laser has an emission wavelength λ and the periodic structure (80) and has a period (87) between 0.5 λ and 1.5 λ, in particular, between 0.7 λ and 1.3 λ.

18. The process according to any of the preceding claims, wherein placement of at least one layer (221) with a periodic structure (80) includes a step of etching by means of a conventional dry chemical and/or wet chemical and/or physical etching process.

19. The process according to claim 18, wherein the step of etching includes the step of etching trenches (81, 82, 83, 84) in the top layer of the second Bragg reflector layer sequence (22).

20. The process according to claim 19, wherein said etching of trenches (81, 82, 83, 84) in the top layer (221) of the second Bragg reflector layer sequence (22) is carried out with an etching depth (88) between 10 and 150 nm, in particular, between 40 and 90 nm.

21. The process according to any of the preceding claims, wherein the step of depositing a dielectric material and/or at least one metal comprises applying at least one layer with a periodic structure.

22. The process according to claim 21, wherein the dielectric material and/or at least one metal is deposited on the top layer of the second Bragg reflector layer sequence (22).

23. The process according to claim 22, wherein the top layer of the second Bragg reflector layer sequence (22) is thinned, in particular, to a layer height between 10 and 150 nm, in particular, between 40 and 90 nm.

24. The process according to any of the preceding claims, wherein the periodic structure (80) has a period (87) of substantially 0.7 micron and the thickness (88) of the periodic structure (80) lies between 40 and 70 nm.

25. The process according to any of the preceding claims, wherein at least one layer of the layer sequence is provided with a further structure such that the power of at least one laser mode is preferably reinforced.

26. A system for optical data transmission, comprising a vertical cavity diode laser (1) according to any of claims 1 to 11.

27. A spectroscopic system, in particular, for measuring absorption lines of which has a vertical cavity diode laser (1) according to any of claims 1 to 11.

## Revendications

1. Diode laser verticale (1), comprenant au moins
un substrat (10),
une première série de couches à réflecteur de Bragg (21) appliquée sur un substrat,
une série de couches active (30) appliquée sur la première série de couches à réflecteur de Bragg (21) pour générer un rayonnement laser,
une deuxième série de couches à réflecteur de Bragg (22) appliquée sur la série de couches active (30) et
un moyen d'application d'une tension sur la série de couches active (30), dans lequel au moins la couche la plus supérieure (221) de la deuxième série de couches à réflecteur de Bragg (22) est structurée périodiquement et dans lequel la période (87) de structuration (80) et la position de la structuration dans la direction du rayon laser (1) sont choisies de telle sorte que la polarisation du laser (1) soit stabilisée,
**caractérisée en ce que**
la couche la plus supérieure (221) de la deuxième série de couches à réflecteur de Bragg (22) présente un évidement (70) sous la forme d'un anneau circulaire au milieu de la surface de sortie de lumière du laser (1), de sorte que le mode fondamental du laser soit renforcé de préférence et la structuration (80) est une structure en réseau qui est disposée sur une proéminence de forme circulaire (75) au milieu de la surface de sortie de lumière du laser (1).

2. Diode laser verticale selon la revendication 1, dans laquelle la première et la deuxième série de couches à réflecteur de Bragg présentent une multiplicité de paires de couches, respectivement, une couche d'une paire de couche présentant un matériau à indice de réfraction élevé et une couche présentant un matériau à indice de réfraction faible et les couches à indices de réfraction élevé et faible étant disposées en alternance.

3. Diode laser verticale (1) selon la revendication 2, dans laquelle au moins la deuxième série de couches à réflecteur de Bragg (22) présente au moins une autre couche.

4. Diode laser verticale (1) selon la revendication 3, dans laquelle l'au moins une autre couche forme la couche la plus supérieure de la deuxième série de couches à réflecteur de Bragg.

5. Diode laser verticale (1) selon l'une des revendications précédentes, dans laquelle la structuration périodique (80) présente une période (87) entre 0,3 et 1,5 µm, en particulier, entre 0,6 et 1,0 µm

6. Diode laser verticale (1) selon l'une des revendications précédentes, la diode laser verticale présentant une longueur d'ondes d'émission de λ et la structuration périodique (80) présentant une période (87) entre 0,5 λ et 1,5 λ, en particulier, entre 0,7 λ et 1,3 λ.

7. Diode laser verticale (1) selon l'une des revendications précédentes, dans laquelle la structuration périodique (80) est formée par les évidements (81, 82, 83, 84) dans la couche la plus supérieure (221) de la deuxième série de couches à réflecteur de Bragg (22).

8. Diode laser verticale (1) selon la revendication 7, dans laquelle les évidements (84) présentent une profondeur (88) entre 10 et 150 nm, en particulier, entre 40 et 90 nm.

9. Diode laser verticale (1) selon l'une des revendications précédentes, dans laquelle la structuration périodique (80) est formée par les proéminences aménagées sur la couche la plus supérieure (221) de la deuxième série de couches à réflecteur de Bragg (22), la couche la plus supérieure (221) de la deuxième série de couches à réflecteur de Bragg (22) étant affinée.

10. Diode laser verticale (1) selon la revendication 9, dans laquelle la couche la plus supérieure (221) de la deuxième série de couches à réflecteur de Bragg (22) entre 10 et 150 nm, en particulier entre 40 et 90 nm, est affinée.

11. Diode laser verticale (1) selon l'une des revendications précédentes, la diode laser verticale (1) présentant une longueur d'ondes d'émission d'essentiellement 850 nm, la structuration périodique (80) présentant une période (87) d'essentiellement 0,7 µm et l'épaisseur (88) de la structuration périodique (80) se situe entre 40 et 70 nm.

12. Procédé de production d'une diode laser verticale stable à la polarisation, comprenant les étapes de
mise à disposition d'un substrat (10),
application d'une première série de couches à réflecteur de Bragg (21) sur le substrat (10),
application d'une série de couches active (30) sur la première série de couches à réflecteur de Bragg (21) pour générer un rayonnement laser,
application d'une deuxième série de couches à réflecteur de Bragg (22) sur la série de couches active (30),
mise en oeuvre d'un moyen d'application d'une tension sur la série de couches active (30), dans lequel
au moins la couche la plus supérieure (221) de la deuxième série de couches à réflecteur de Bragg (22) est appliquée avec une structuration périodique (80) et dans lequel la période (87) de structuration et la position de la structuration dans la direction du rayon laser (1) sont choisies de telle sorte que la polarisation du laser (1) soit stabilisée,
**caractérisé par** l'étape de gravure d'un évidement (70) présentant une section sous la forme d'un anneau circulaire dans la couche la plus supérieure (221) de la deuxième série de couches à réflecteur de Bragg (22) de sorte qu'un évidement de forme circulaire (75) soit formé au milieu de la surface de sortie de lumière du laser (1),
de sorte que la performance du mode fondamental du laser soit renforcée de préférence et la structuration (80) est une structure en réseau qui est disposée sur une proéminence de forme circulaire (75) au milieu de la surface de sortie de lumière du laser (1).

13. Procédé selon la revendication 12, dans lequel la première et la deuxième série de couches à réflecteur de Bragg sont appliquées sous la forme d'une multiplicité de paires de couches, dans lequel respectivement, une couche d'une paire de couche présente un matériau à indice de réfraction élevé et une couche présente un matériau à indice de réfraction faible et les couches à indices de réfraction élevé et faible sont disposées en alternance.

14. Procédé selon la revendication 13, dans lequel pour la formation de la deuxième série de couches à réflecteur de Bragg (22), au moins une autre couche est appliquée.

15. Procédé selon la revendication 14, dans lequel l'au moins une autre couche est appliquée en tant que couche la plus supérieure de la deuxième série de couches à réflecteur de Bragg.

16. Procédé selon l'une des revendications précédentes, dans lequel la structuration périodique (80) présente une période (87) entre 0,3 et 1,5 µm, en particulier, entre 0,6 et 1,0 µm.

17. Procédé selon l'une des revendications précédentes, dans lequel la diode laser verticale (1) présente une longueur d'ondes d'émission de λ et la structuration périodique (80) présente une période (87) entre 0,5 λ et 1,5 λ, en particulier, entre 0,7 λ et 1,3 λ.

18. Procédé selon l'une des revendications précédentes, dans lequel l'application de l'au moins une couche (221) présentant une structuration périodique (80) comprend l'étape de gravure au moyen de procédés de gravure chimique à sec et/ou de gravure chimique à l'état humide et/ou de moyens physiques classiques.

19. Procédé selon la revendication 18, dans lequel l'étape de gravure comprend l'étape de gravure de sillons (81, 82, 83, 84) dans la couche la plus supérieure de la deuxième série de couches à réflecteur de Bragg (22).

20. Procédé selon la revendication 19, dans lequel la gravure de sillons (81, 82, 83, 84) s'effectue dans la couche la plus supérieure (221) de la deuxième série de couches à réflecteur de Bragg (22) avec une profondeur de gravure (88) entre 10 et 150 nm, en particulier, entre 40 et 90 nm.

21. Procédé selon l'une des revendications précédentes, dans lequel l'application de l'au moins une couche présentant une structuration périodique comprend l'étape de dépôt d'un matériau diélectrique et/ou d'au moins un métal.

22. Procédé selon la revendication 21, dans lequel le matériau diélectrique et/ou l'au moins un métal est déposé sur la couche la plus supérieure de la deuxième série de couches à réflecteur de Bragg (22).

23. Procédé selon la revendication 22, dans lequel la couche la plus supérieure de la deuxième série de couches à réflecteur de Bragg (22) est affinée, en particulier, autour d'une hauteur de couche entre 10 et 150 nm, en particulier, entre 40 et 90 nm.

24. Procédé selon l'une des revendications précédentes, dans lequel la structuration périodique (80) présente une période (87) d'essentiellement 0,7 µm et l'épaisseur (88) de la structuration périodique (80) se situe entre 40 et 70 nm.

25. Procédé selon l'une des revendications précédentes, dans lequel au moins une couche de la série de couches est appliquée avec une autre structuration de telle sorte que la performance d'au moins un mode laser de préférence soit renforcée.

26. Système de transmission optique de données qui présente une diode laser verticale (1) selon l'une des revendications 1 à 11.

27. Système spectroscopique, en particulier, pour mesurer des lignes d'absorption, qui présente une diode laser verticale (1) selon l'une des revendications 1 à 11.
